# EUROPEAN PATENT SPECIFICATION

(11) **EP 1 391 786 B1**
(45) Date of publication and mention of the grant of the patent: **06.10.2010**
(21) Application number: 03255161.6
(22) Date of filing: 20.08.2003
(51) Int. Cl.: G03F 7/20, H01L 21/00, H01L 21/68

(54) **Chuck, lithographic apparatus and device manufacturing method**
Halter, lithographisches Gerät und Verfahren zur Herstellung einer Vorrichtung
Support, appareil lithographique et méthode de fabrication d'un dispositif

(30) Priority: 23.08.2002 EP 02255915
(43) Date of publication of application: 25.02.2004
(73) Proprietor: ASML Netherlands B.V., 5504 DR Veldhoven (NL)
(72) Inventor: Hoeks, Martinus Hendricus Hendricus, 5694 SL Breugel (NL); Ottens, Joost Jeroen, 5508 TR Veldhoven (NL)
(74) Representative: Slenders, Petrus J. W.

(56) References cited:
- EP-A- 0 720 217
- EP-A- 0 803 904
- US-A- 4 502 094
- US-A- 5 160 152
- US-A- 5 923 408
- US-A1- 2002 101 956

## Description

The present invention relates to a chuck for use in holding an article onto a supporting table by electrostatic force: said article being
- a substrate to be processed in manufacturing devices employing lithographic protection techniques; or
- a lithographic projection mask or mask blank in a lithographic projection apparatus, a mask handling apparatus such as mask inspection or cleaning apparatus, or a mask manufacturing apparatus; said chuck comprising: a first dielectric member.

The present invention also relates to a lithographic projection apparatus comprising:
a radiation system for supplying a projection beam of radiation;
   - a support structure for supporting patterning means, the patterning means serving to pattern the projection beam according to a desired pattern;
   - a substrate table for holding a substrate;
   - a projection system for projecting the patterned beam onto a target portion of the substrate;
   - a chuck comprising a dielectric member on said support structure or said substrate table; and
   - at least a first electrode for applying a potential difference across said dielectric member of said chuck thereby to generate a clamping force.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required.
- A programmable LCD array. An example of such a construction is given in United States Patent US 5,229,872. As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus-commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

In a lithographic apparatus it is essential that the substrate is held securely on the substrate table. The position of the substrate is required to be known accurately, even when the table undergoes high accelerations. In a conventional lithographic apparatus it is known to provide this clamping by means of a vacuum. The substrate table is provided with protrusions or pins and an outer wall. The substrate sits on top of these pins and the space behind it is evacuated. The action of air pressure on the surface on the substrate then serves to hold it securely in place. Further details of such a substrate holder can be found, for example, in EP-A-0 947 884.

While such a clamp is effective in many applications, recent developments in lithography require the use of EUV (extreme ultraviolet) radiation, x-rays, electrons or ions. Unlike conventional lithography in which UV radiation is employed, EUV techniques require that the beam path, or at least a substantial part of the beam path, is evacuated. The vacuum clamping method is then less effective.

It has been proposed to provide a system of clamping for use in a lithographic apparatus which uses electrostatic forces to clamp the substrate to the substrate table. Such a system will work regardless of the presence of a vacuum on both sides of the substrate. In such a system, the substrate is either conductive, or provided with a conductive electrode on the surface which is to be attached to the substrate table. An electrode static chuck consists of one or more electrodes. On top of the electrodes a layer of dielectric material is placed. The top surface of this layer is usually patterned to reduce the contact area between substrate and chuck. A potential difference between the electrode and the substrate (mono-polar design) or between the two or more electrodes in the chuck itself (bi-polar and multi-polar design) is set to generate an electro-static force to clamp the substrate to the chuck.

Typically, the dielectric will have a polished smooth surface. However, in a practical situation the surface of the substrate and the dielectric will never be perfectly smooth and will contain small variations. Furthermore, although the resistivity of the dielectric is extremely high (greater than 10⁸Ωm) a small leakage current will flow. This leads to the creation of Johnsen-Rahbek (JR) forces additional to the capacitative electrostatic force. These forces arise due to the flow of the leakage current between points where the substrate and dielectric are in contact. At points where the substrate and dielectric are not in contact, charge builds up and creates an additional JR force. When the potential difference is removed, the stored charge creating the JR force takes time to dissipate, and introduces a delay before the substrate can be released from the chuck. It has been proposed to apply a reverse voltage in the release stage, to dissipate the charge more quickly. It has also been proposed to cycle the polarity of the applied voltage to minimize the charge build-up. However a relatively high cycle frequency is required and complicated schemes are required to maintain the clamping force at all times.

US 4,502,094 describes an electrostatic chuck for holding a semiconductor wafer flat in a charged particle beam. Copper pins support the wafer and extend through the chuck to assist in dissipation of heat from the wafer.

It is an object of the present invention to provide a chuck in which the Johnsen-Rahbek effect may be minimized, allowing greater throughput of substrates.

This and other objects are achieved according to the invention in a chuck as defined in the appended claims.

Thus the effect of the JR forces is minimized. The presence of the conductive layer eliminates JR forces in all places where the pins are in contact with the substrate. Furthermore, the surface of the dielectric member apart from the pins is located a sufficient distance away from the substrate that the Johnsen-Rahbek force is negligible. The actual area of the pins in contact with the substrate is minimal, so the overall electrostatic force is only very slightly smaller than if the dielectric were flat. In this way the substrate is clamped effectively by electrostatic force under an applied potential difference and can be released quickly when the potential difference is removed.

The conductive layer is less than 200nm thick. Having a thin coating will ease the control of the flatness of the chuck. Furthermore a standard CVD process can be used to manufacture this layer.

Advantageously, the conductive layer may not be a metal. If a metal is used then metal atoms can diffuse into the substrate at the points of contact and destroy the semiconducting properties.

Preferably the thickness of the dielectric member is 50-200µm. This allows sufficient depth to form the structure of pins, and provides an optimal distance over which the electrostatic force may operate, without the risk of breakdown in the dielectric.

Advantageously, the total area of pins can be kept to less than 4% of the total area of the dielectric member. This ensures that any effects on the electrostatic force due to the contact between the conducting layer of the pins and the substrate is minimized.

In an advantageous configuration, the pins project 2-10µm from the dielectric member. This distance is sufficient to render the Johnsen-Rahbek effect negligible over those areas of the dielectric without pins. Furthermore, the mechanical properties of the pins when a clamping force is applied are improved due to their relatively small height.

The pins may be between 0.15mm to 0.5mm in diameter, and spaced between 2 to 15 mm apart. This ensures a large area of the dielectric member does not contain pins, and thus is effective for generating an electrostatic clamping force. It also means that the diameter of the pins is greater than their height, enhancing their mechanical properties. Furthermore, by providing the pins at 2 to 15 mm spacing an even force can be applied while supporting the whole area of the substrate. Any distortion of the substrate under clamping is therefore minimized. The dielectric member will typically have hundreds or thousands of pins, ensuring that at least some are in contact with the substrate.

According to another aspect of the invention there is provided a lithographic projection apparatus as defined in the appended claims.

According to a further aspect of the invention there is provided a device manufacturing method as defined in the appended claims.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range 5-20 nm), as well as particle beams, such as ion beams or electron beams.

Embodiments of the invention will now be described, by way of example only, with reference to the accompanying schematic drawings in which:
Figure 1 depicts a lithographic projection apparatus according to an embodiment of the invention;
Figure 2 depicts a chuck in accordance with a first embodiment of the present invention;
Figure 3 depicts a chuck of a first comparative example;
Figure 4 illustrates a chuck and associated control circuitry in schematic format of a second comparative example; and
Figure 5 is a plan view of the electrode pattern of a bipolar chuck according to a third comparative example;
Figure 6 depicts a chuck in accordance with a fourth comparative example; and
Figure 7 depicts a chuck in accordance with a second embodiment of the present invention.

In the Figures, corresponding reference symbols indicate corresponding parts.

### Embodiment 1

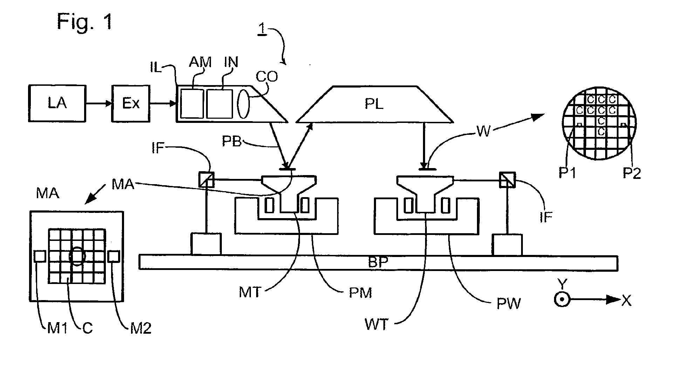

Figure 1 schematically depicts a lithographic projection apparatus according to a particular embodiment of the invention. The apparatus comprises:
a radiation system Ex, IL, for supplying a projection beam PB of radiation (e.g. EUV radiation), which in this particular case also comprises a radiation source LA;
a first object table (mask table) MT provided with a mask holder for holding a mask MA (e.g. a reticle), and connected to first positioning means for accurately positioning the mask with respect to item PL;
a second object table (substrate table) WT provided with a substrate holder for holding a substrate W (e.g. a resist-coated silicon wafer), and connected to second positioning means for accurately positioning the substrate with respect to item PL;
a second object table (substrate table) WT provided with a substrate holder for holding a substrate W (*e.g.* a resist-coated silicon wafer), and connected to second positioning means for accurately positioning the substrate with respect to item PL;
a projection system ("lens") PL (*e.g* mirror group) for imaging an irradiated portion of the mask MA onto a target portion C (*e.g.* comprising one or more dies) of the substrate W.

As here depicted, the apparatus is of a reflective type (*e.g.* has a reflective mask). However, in general, it may also be of a transmissive type, for example (*e.g.* with a transmissive mask). Alternatively, the apparatus may employ another kind of patterning means, such as a programmable mirror array of a type as referred to above.

The source LA (*e.g.* a laser-produced or discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (*e.g.* with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed v, so that the projection beam PB is caused to scan over a mask image; concurrently, the substrate table WT is simultaneously moved in the same or opposite direction at a speed *V = Mv,* in which *M* is the magnification of the lens PL (typically, *M* = 1/4 or 1/5). In this manner, a relatively large target portion C can be exposed, without having to compromise on resolution.

It has been noted above that an EUV system requires that a beam path is evacuated. This may be achieved by a single vacuum system which encloses the entire apparatus, or by several separate interlinked vacuum systems.

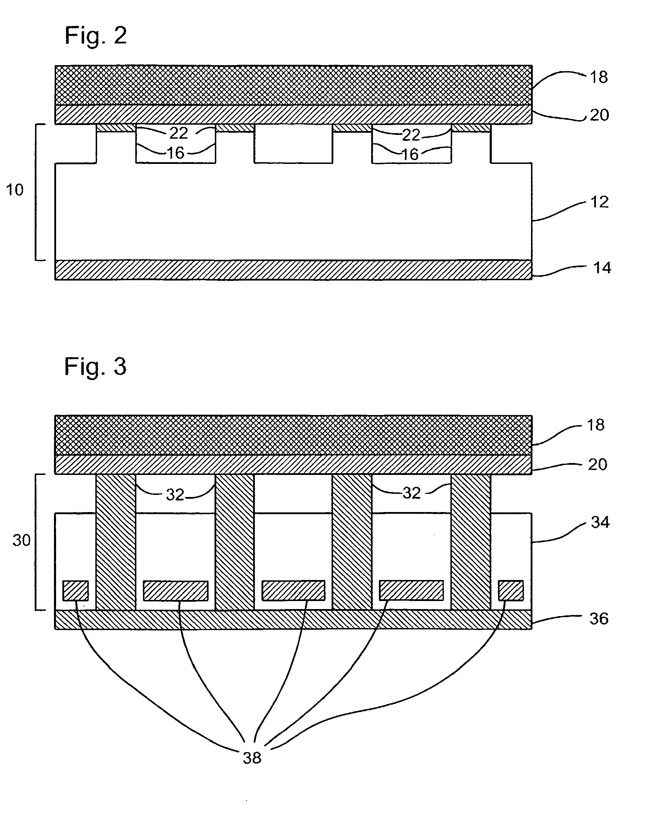

Figure 2 illustrates the chuck 10 used in the first embodiment. The chuck 10 consists of a dielectric member 12 with an electrode 14 formed on one surface. On the opposite side of the dielectric member 12 to the electrode 14 a plurality of pins 16 are formed. These pins 16 are 0.3mm in diameter and rise above the surface of the dielectric member 12 by 5µm. The top 100nm of each pin 16 is formed as a conductive layer. The conductive layer is, for example, TiN.

The chuck of the present embodiment is used to clamp a substrate 18. The substrate 18 is non-conductive, so an electrode 20 is formed on its clamping surface. When it is desired to clamp the substrate 18 using the chuck 10 a potential difference is applied between the electrodes 20 and 14. The capacitive effect produces an electrostatic force which clamps the substrate 18 to the chuck 10. It will be appreciated that the portions of the electrode 20 which are in contact with the upper conducting layer 22 of the pins 16 will not function as a capacitor. Here the direct connection between two conducting surfaces allows charge to flow freely and prevents the creation of Johnsen-Rahbek forces. Because the pins account for only a small proportion (0.5% to 4%) of the area of the dielectric member 12 the electrostatic force is reduced only by a small amount.

It cannot be assumed that the surface of electrode 20 is perfectly smooth, so not all the conducting layers 22 will be in contact with the electrode 20. In these areas there will be a small gap (of the order of 10nm) in which the Johnsen-Rahbek effect may occur. However, because the capacitance of the conducting layer is very small, the force is also very small. The Johnsen-Rahbek effect will still occur in the surface of the dielectric member 12 which does not have pins 16 present. However, the 5µm spacing between this surface and the top of the pins 16 ensures that Johnsen-Rahbek forces in this area are negligible.

It will be appreciated that while the above embodiment describes a non-conducting substrate 18 formed with an electrode 20, a conducting substrate (not illustrated) could be used. There would then be no need to form the electrode 20. In this situation a potential difference would be applied between the conducting substrate and the electrode 14. Furthermore, it will be appreciated that the chuck 10 may be permanently or removably attached to a substrate table (not illustrated).

Thus, according to the first embodiment of the present invention it is possible to achieve an electrostatic clamping which is not influenced by the Johnsen-Rahbek effect. This allows throughput of substrates to be increased because there is no delay introduced while waiting for the Johnsen-Rahbek force to subside to a level where the substrate can be released from the clamp after the potential difference is removed.

It is still possible that if the polarity of the electrodes 14 and 20 is kept constant charge may build up and the Johnsen-Rahbek effect may become important. As described above the design of the chuck 10 minimizes the effect. However, to eliminate any potential build up of the Johnsen-Rahbek effect it is possible to alternate the polarity of voltages applied to the electrodes 20 and 14 each time the substrate is changed. This ensures that no charge builds up in the dielectric member 12. Furthermore, no complicated control techniques are required to reverse the polarity while the substrate is clamped. While it is advisable to alternate the voltage every time the wafer is changed, the effect of the Johnsen-Rahbek force has been found to be so small that a cycle in which the plurality is alternated over a longer period of time, up to two hours, is also suitable.

Figure 3 illustrates a clamping chuck 30 as a comparative example, which is the same as the first embodiment, save as described below. The chuck 30 is provided with a number of pins 32, similar to grounding pins, which extend through the entire depth of a dielectric member 34. The pins 32 are formed by a conductive material. The conducting pins 32 are connected to a conductor 36 which is disposed on the side of the chuck 30 which is not used for clamping a substrate 18. An electrode 38 is provided in the dielectric member 34 away from the clamping surface and insulated from both the pins 32 and the conductor 36 by the dielectric member 34.

The chuck clamps the substrate 18 when a voltage is applied to the electrodes 38. It is possible that, in this embodiment the substrate 18 is grounded. However, it is still advisable to alternate the applied voltage in a similar fashion to the first embodiment.

The dimensions and arrangement of the projecting parts of the pins in the second embodiment are the same as those of the pins in the first embodiment, so will not be described again.

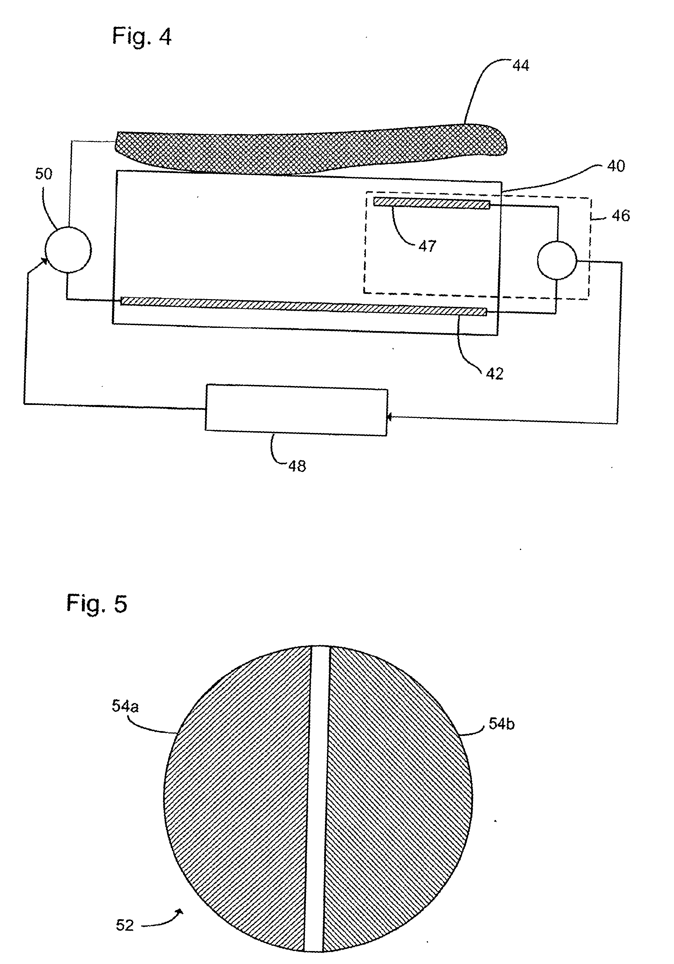

A clamping chuck according to a second comparative example in which the scale of microscopic surface variations on the substrate 44 has been exaggerated for reference purposes is illustrated in Figure 4. The reference chuck is the same as the first embodiment, save as described below. While the aforementioned first embodiment and the cluch according to the first comparative example of Figure 3 have minimized the effects of Johnsen-Rahbek forces to enable a substrate to be released quickly when the clamping potential difference is removed, the third embodiment aims to control the Johnsen-Rahbek forces to a manageable level. It is then possible to benefit from the additional Johnsen-Rahbek Force, and minimize any delay introduced during the clamping/declamping process. In the third embodiment the clamping surface of the dielectric member 40 is preferably polished flat. However, it will be appreciated that the clamping surface does not have to be polished flat.

An electrode 42 is provided on the surface of the dielectric member 40 which is opposite the clamping surface. To clamp a substrate 44 a potential difference is applied between the electrode 42 and the substrate 44. The third embodiment comprises a dielectric member 40; at least a first electrode 42; a voltage source 50 for providing a voltage between said first electrode and a substrate; a sensor 46 for sensing charge migration within the dielectric member 40; and control system 48 for controlling the voltage source 50 based on the output of the sensor 46.

As the potential difference is applied between the substrate 44 and the electrode 42, the charge within the dielectric begins to migrate. This reduces the effective distance and causes the Johnsen-Rahbek effect in areas where, due to microscopic surface variations of the substrate 44, the substrate 44 is not in contact with the dielectric member 40.

However, in this reference example a sensor 46 is provided to measure the charge migration within the dielectric member 40. The sensor 46 includes an upper short electrode 47 within the dielectric member 40. This is processed by a control system 48 using a closed loop method to control the applied potential difference. The Johnsen-Rahbek force can therefore be controlled closely, and limited to a value which will subside when the potential difference is removed minimizing the delay before the substrate is released. Thus, it is possible to benefit from the increased clamping force created by the Johnsen-Rahbek effect while also minimizing any delay in releasing the substrate when the potential difference is removed. It will be appreciated that the control system 48 may apply a reverse voltage in the release phase to dissipate the stored charge as quickly as possible.

In this reference example, and as illustrated in Figure 4 a conducting substrate 44 is used. However, a non-conducting substrate with an electrode on the clamping surface could be used instead, as described in relation to the above first embodiment and the first comparative example. Furthermore, the control system and sensor of this reference example may be applied to the above first and second embodiments.

The above described embodiment and examples have considered mono-polar chucks. The third example uses a bipolar chuck. The construction of the third example is as for the first embodiment save as described below.

A plan view of the electrodes of a bipolar chuck 52 is illustrated in Figure 5. The circular chuck 52 has two semi-circular electrodes 54a and 54b instead of the single electrode 14 of the first embodiment. When it is desired to clamp a substrate to the chuck 52, a voltage of + 100V is applied to one electrode and - 100V to the other; the substrate will then be at zero potential.

There is therefore no requirement to use a conducting substrate or a substrate with a conducting layer. Consequently no electrical connections to the substrate is required.

Other structures of the bipolar design are possible, for example, the two electrodes may comprise an arrangement of interlocking fingers, a Greek key pattern, concentric rings or concentric spirals. A multi-polar design may also be used.

It will be appreciated that the electrode of the third example may also be applied to the chuch of the first comparative example, removing the requirement for a conducting substrate or a substrate with a conducting layer.

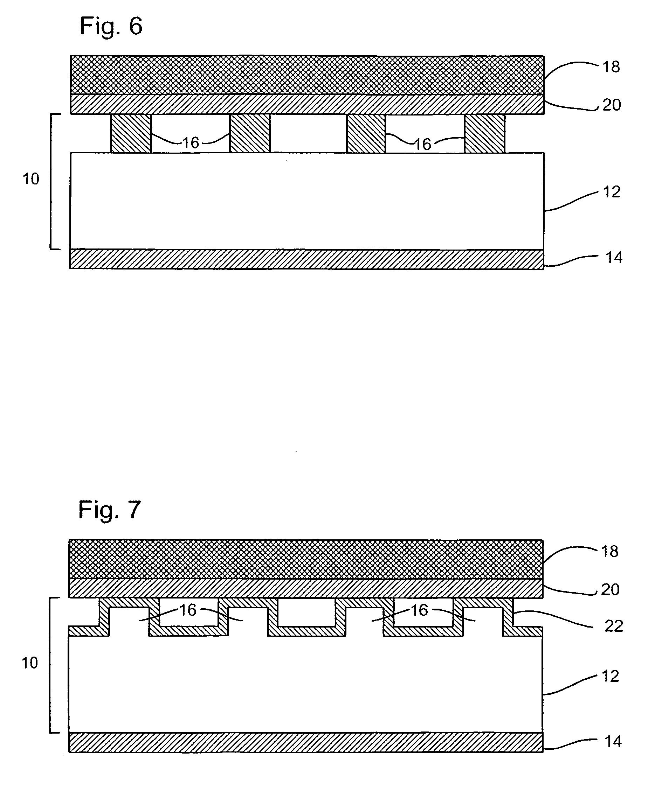

A fourth example of a clamping chuck according to the invention is illustrated in Figure 6. The fourth example is the same as the first embodiment, save as described below. The chuck 10 again consists of a dielectric member 12 with an electrode 14 formed on one surface. On the opposite side of the dielectric member 12 a number of pins 16 are formed. Contrary to the first embodiment, the pins 16 are conducting pins 16 which are mounted on the surface of the dielectric member 12 facing the electrode 20.

The dimensions and arrangement of the projecting parts of the pins 16 in the fourth example are the same as those of the pins in the first embodiment and will therefore not be described again.

A second embodiment of a clamping chuck according to the invention is illustrated in Figure 7. The second embodiment is the same as the first embodiment, save as described below. In the second embodiment the conductive layer 22 is also provided on the area between the respective pins 16. Therefore the area of the dielectric member 12 facing the electrode 20 is completely covered by the conductive layer 22.

Whilst specific embodiments of the invention have been described above, it will be appreciated that the invention may be practiced otherwise than as described. The description is not intended to limit the invention.

## Claims

1. A chuck for use in holding an article on to a supporting table by electrostatic force, said article being:
- a substrate (18) to be processed in manufacturing devices employing lithographic projection techniques; or
- a lithographic projection mask (MA) or mask blank in a lithographic projection apparatus, a mask handling apparatus such as mask inspection or cleaning apparatus, or a mask manufacturing apparatus;
said chuck comprising:
a dielectric member (12) having a side facing said article that is provided with a plurality of pins (16), wherein a layer (22) on the surface of each of said pins in contact with said article is conductive and formed of a material having a specific resistivity less than 10Ωm; **characterised in that**:
said layer (22) is less than 200nm thick.

2. A chuck according to claim 1 or 2, wherein said conductive layer (22) is non-metallic

3. A chuck according to any one of the preceding claims, wherein the thickness of said dielectric member (12) is in the range of from 50 to 200µm.

4. A chuck according to any one of the preceding claims, wherein the surface area of said pins (16) which is in contact with said article (18;MA) is less than 4% of the total area of the dielectric member (12).

5. A chuck according to any preceding claim, wherein said pins project in the range of from 2 to 10µm from the surface of the dielectric member.

6. A chuck according to any one of the preceding claims, wherein said pins (16) have a diameter in the range of from 0.15mm to 0.5mm.

7. A chuck according to any one of the preceding claims, wherein said pins (16) are spaced apart by a distance in the range of from 2 to 15mm.

8. A chuck according to any one of the preceding claims, wherein the surface of the dielectric member (12) facing the article is provided with a conductive layer.

9. A lithographic projection apparatus comprising:
- a radiation system (IL) for providing a projection beam of radiation;
- a support structure (MT) for supporting patterning means, the patterning means serving to pattern the projection beam according to a desired pattern;
- a substrate table (WT) for holding a substrate;
- a projection system (PL) for projecting the pattern beam on to a target portion of the substrate;
- a chuck (10) according to any one of the preceding claims on said support structure or said substrate table; and
- at least one electrode (14) for applying a potential difference across the said dielectric member of said chuck thereby to generate a clamping force.

10. A device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material,
- providing an electrostatic chuck for holding said substrate to said substrate table, said electrostatic chuck being in accordance with any one of claims 1 to 8.

## Patentansprüche

1. Eine Spannvorrichtung zur Verwendung beim Halten eines Gegenstands auf einem Stütztisch durch elektrostatische Kraft, wobei der Gegenstand wie folgt ist:
- ein Substrat (18), das bei der Herstellung von Vorrichtungen unter Einsatz lithographischer Projektionstechniken verarbeitet werden soll; oder
- eine lithographische Projektionsmaske (MA) oder ein Maskenrohling in einem lithographischen Projektionsgerät, einem Maskenhandhabungsgerät wie etwa einem Maskeninspektions- oder -reinigungsgerät oder einem Maskenherstellungsgerät;
wobei die Spannvorrichtung Folgendes beinhaltet:
ein dielektrisches Element (12), das eine zum Gegenstand weisende Seite aufweist, die mit einer Vielzahl von Stiften (16) versehen ist, wobei eine Schicht (22) auf der Oberfläche jedes der Stifte, die sich mit dem Gegenstand in Kontakt befindet, leitend ist und aus einem Material gebildet ist, das einen spezifischen Widerstand von weniger als 10 Ωm aufweist; **dadurch gekennzeichnet, dass**:
die Schicht (22) weniger als 200 nm dick ist.

2. Spannvorrichtung gemäß Anspruch 1 oder 2, wobei die leitende Schicht (22) nicht metallisch ist.

3. Spannvorrichtung gemäß einem der vorhergehenden Ansprüche, wobei die Dicke des dielektrischen Elements (12) in dem Bereich von 50 bis 200 µm liegt.

4. Spannvorrichtung gemäß einem der vorhergehenden Ansprüche, wobei der mit dem Gegenstand (18; MA) in Kontakt befindliche Oberflächenbereich der Stifte (16) weniger als 4 % der Gesamtfläche des dielektrischen Elements (12) beträgt.

5. Spannvorrichtung gemäß einem der vorhergehenden Ansprüche, wobei die Stifte in dem Bereich von 2 bis 10 µm von der Oberfläche des dielektrischen Elements vorstehen.

6. Spannvorrichtung gemäß einem der vorhergehenden Ansprüche, wobei die Stifte (16) einen Durchmesser in dem Bereich von 0,15 mm bis 0,5 mm aufweisen.

7. Spannvorrichtung gemäß einem der vorhergehenden Ansprüche, wobei die Stifte (16) um eine Entfernung in dem Bereich von 2 bis 15 mm mit Abstand voneinander angeordnet sind.

8. Spannvorrichtung gemäß einem der vorhergehenden Ansprüche, wobei die zum Gegenstand weisende Oberfläche des dielektrischen Elements (12) mit einer leitenden Schicht versehen ist.

9. Ein lithographisches Projektionsgerät, das Folgendes beinhaltet:
- ein Strahlungssystem (IL) zum Bereitstellen eines Projektionsstrahls aus Strahlung;
- eine Stützstruktur (MT) zum Stützen eines Musterungsmittels, wobei das Musterungsmittel dazu dient, den Projektionsstrahl gemäß einem gewünschten Muster zu mustern;
- einen Substrattisch (WT) zum Halten eines Substrats;
- ein Projektionssystem (PL) zum Projizieren des Musterstrahls auf einen Zielabschnitt des Substrats;
- eine Spannvorrichtung (10) gemäß einem der vorhergehenden Ansprüche auf der Stützstruktur oder dem Substrattisch und
- mindestens eine Elektrode (14) zum Anlegen einer Potenzialdifferenz über das dielektrische Element der Spannvorrichtung, um **dadurch** eine Klemmkraft zu erzeugen.

10. Ein Verfahren zum Herstellen einer Vorrichtung, das die folgenden Schritte beinhaltet:
- Bereitstellen eines Substrats, das mindestens teilweise mit einer Schicht aus strahlungsempfindlichem Material überzogen ist;
- Bereitstellen eines Projektionsstrahls aus Strahlung unter Verwendung eines Strahlungssystems;
- Verwenden eines Musterungsmittels, um den Projektionsstrahl in seinem Querschnitt mit einem Muster zu versehen;
- Projizieren des gemusterten Strahls aus Strahlung auf einen Zielabschnitt der Schicht aus strahlungsempfindlichem Material;
- Bereitstellen einer elektrostatischen Spannvorrichtung zum Halten des Substrats an dem Substrattisch, wobei die elektrostatische Spannvorrichtung einem der Ansprüche 1 bis 8 entspricht.

## Revendications

1. Un mandrin destiné à maintenir un article sur une table servant de support grâce à une force électrostatique, ledit article étant :
- un substrat (18) devant être traité dans des dispositifs de fabrication employant des techniques de projection lithographique ; ou
- un masque de projection lithographique (MA) ou une découpe de masque dans un appareil de projection lithographique, un appareil de manipulation de masque tel qu'un appareil d'inspection ou de nettoyage de masque, ou un appareil de fabrication de masque ;
ledit mandrin comprenant :
un élément diélectrique (12) dont un côté qui fait face audit article est pourvu d'une pluralité de broches (16), où une couche (22) sur la surface de chacune desdites broches en contact avec ledit article est conductrice et formée d'un matériau ayant une résistivité spécifique inférieure à 10 Ωm ; **caractérisé en ce que** :
ladite couche (22) fait moins de 200 nm d'épaisseur.

2. Un mandrin selon la revendication 1 ou la revendication 2, où ladite couche conductrice (22) est non métallique.

3. Un mandrin selon l'une quelconque des revendications précédentes, où l'épaisseur dudit élément diélectrique (12) est comprise dans la gamme allant de 50 à 200 µm.

4. Un mandrin selon l'une quelconque des revendications précédentes, où l'aire de la surface desdites broches (16) qui se trouve au contact dudit article (18 ; MA) fait moins de 4 % de l'aire totale de l'élément diélectrique (12).

5. Un mandrin selon n'importe quelle revendication précédente, où l'étendue sur laquelle lesdites broches font saillie de la surface de l'élément diélectrique va de 2 à 10 µm.

6. Un mandrin selon l'une quelconque des revendications précédentes, où lesdites broches (16) ont un diamètre compris dans la gamme allant de 0,15 mm à 0,5 mm.

7. Un mandrin selon l'une quelconque des revendications précédentes, où lesdites broches (16) sont espacées les unes des autres d'une distance comprise dans la gamme allant de 2 à 15 mm.

8. Un mandrin selon l'une quelconque des revendications précédentes, où la surface de l'élément diélectrique (12) qui fait face à l'article est pourvue d'une couche conductrice.

9. Un appareil de projection lithographique comprenant :
- un système de rayonnement (IL) destiné à fournir un faisceau de projection de rayonnement ;
- une structure formant support (MT) destinée à servir de support à un moyen pour conformer selon un motif, le moyen pour conformer selon un motif servant à conformer le faisceau de projection selon un motif souhaité ;
- une table porte-substrat (WT) destinée à porter un substrat ;
- un système de projection (PL) destiné à projeter le faisceau à motif sur une portion cible du substrat ;
- un mandrin (10) selon l'une quelconque des revendications précédentes sur ladite structure formant support ou ladite table porte-substrat ; et
- au moins une électrode (14) destinée à appliquer une différence de potentiel aux bornes dudit élément diélectrique dudit mandrin pour générer de ce fait une force de serrage.

10. Un procédé de fabrication de dispositif comprenant les étapes de :
- fournir un substrat qui est au moins partiellement recouvert d'une couche de matériau sensible au rayonnement ;
- fournir un faisceau de projection de rayonnement à l'aide d'un système de rayonnement ;
- utiliser un moyen pour conformer selon un motif afin de doter le faisceau de projection d'un motif dans sa coupe transversale ;
- projeter le faisceau de rayonnement à motif sur une portion cible de la couche de matériau sensible au rayonnement,
- fournir un mandrin électrostatique pour maintenir ledit substrat sur ladite table porte-substrat, ledit mandrin électrostatique étant conforme à l'une quelconque des revendications 1 à 8.
